(19) Europäisches Patentamt
European Patent Office
Office européen des brevets

(11) EP 4 653 882 A1

(12) EUROPEAN PATENT APPLICATION

(43) Date of publication:
26.11.2025 Bulletin 2025/48

(21) Application number: 24177381.1

(22) Date of filing: 22.05.2024

(51) International Patent Classification (IPC):
G01R 27/14 (2006.01)   G01R 27/08 (2006.01)

(52) Cooperative Patent Classification (CPC):
G01R 27/14; G01R 27/08; G01R 27/205

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: Infineon Technologies AG
85579 Neubiberg (DE)

(72) Inventors:
• SAUER, Alexander
81675 München (DE)
• GERLACH, Udo
81547 München (DE)
• FRANK, Oliver
85579 Neubiberg (DE)

(74) Representative: 2SPL Patentanwälte PartG mbB
Landaubogen 3
81373 München (DE)

Remarks:
Amended claims in accordance with Rule 137(2) EPC.

(54) METHOD FOR DETERMINING AT LEAST ONE OF A FIRST CONTACT RESISTANCE AND A SECOND CONTACT RESISTANCE OF A TWO-WIRE KELVIN CONNECTION

(57) Provided is a method for determining at least one of a first contact resistance and a second contact resistance of a two-wire Kelvin connection formed by contact of a first measurement path and a second measurement path of a testing apparatus with a Device Under Test (DUT). The method includes, during a first measurement with both the first measurement path and the second measurement path coupled to the DUT, supplying a predefined measurement current to the DUT via the first measurement path and measuring a first voltage at an input node of internal circuitry of the DUT to which the first and second measurement path are coupled. The method further includes at least one of a second measurement with only the first measurement path coupled to the DUT for determining the first CRES and a third measurement with only the second measurement path coupled to the DUT for determining the second CRES. Said second measurement includes supplying the predefined measurement current to the DUT via the first measurement path and measuring a second voltage at a first node of the first measurement path. Said third measurement includes supplying the predefined measurement current to the DUT via the second measurement path and measuring a third voltage at a second node of the second measurement path. The method further includes determining the at least one of the first CRES and the second CRES. The first CRES is determined based on the predefined measurement current, the first voltage and the second voltage. The second CRES is determined based on the predefined measurement current, the first voltage and the third voltage.

Fig. 1

## Description

### Field

The present disclosure relates to determining Contact RESistances (CRESs) of two-wire Kelvin connections. In particular, examples of the present disclosure relates to a testing apparatus and a method for determining at least one of a first CRES and a second CRES of a two-wire Kelvin connection.

### Background

The two-wire Kelvin connection, also known as the Kelvin sense connection or Kelvin measurement, is a method used in electrical measurements to minimize errors caused by the resistance of connecting wires. It is commonly employed in situations where accurate measurements or supply of low-resistance components are necessary, such as in the testing of electrical circuits, sensors, or materials with low resistivity.

At the points where the wires of the two-wire Kelvin connection make contact with a Device Under Test (DUT), a respective CRES is introduced. The CRES can affect the accuracy of the measurement or supply, particularly when measuring or supplying low-resistance components or materials.

Hence, there may be a demand for determining the CRES of two-wire Kelvin connections.

### Summary

This demand is met by the subject-matter of the independent claims. Advantageous embodiments are addressed by the dependent claims.

According to a first aspect, the present disclosure provides a method for determining at least one of a first CRES and a second CRES of a two-wire Kelvin connection formed by contact of a first measurement path and a second measurement path of a testing apparatus with a DUT. The method comprises, during a first measurement with both the first measurement path and the second measurement path coupled to the DUT, supplying a predefined measurement current to the DUT via the first measurement path and measuring a first voltage at an input node of internal circuitry of the DUT to which the first and second measurement path are coupled. The method further comprises at least one of a second measurement with only the first measurement path coupled to the DUT for determining the first CRES and a third measurement with only the second measurement path coupled to the DUT for determining the second CRES. Said second measurement comprises supplying the predefined measurement current to the DUT via the first measurement path and measuring a second voltage at a first node of the first measurement path. Said third measurement comprises supplying the predefined measurement current to the DUT via the second measurement path and measuring a third voltage at a second node of the second measurement path. The method further comprises determining the at least one of the first CRES and the second CRES. The first CRES is determined based on the predefined measurement current, the first voltage and the second voltage. The second CRES is determined based on the predefined measurement current, the first voltage and the third voltage.

According to a second aspect, the present disclosure provides testing apparatus configured to perform the method according to the first aspect.

According to a third aspect, the present disclosure provides a non-transitory machine-readable medium having stored thereon a program having a program code for causing a testing apparatus to perform the method according to the second aspect, when the program is executed on a processor or a programmable hardware of the testing apparatus.

According to a fourth aspect, the present disclosure provides a program having a program code for causing a testing apparatus to perform the method according to the second aspect, when the program is executed on a processor or a programmable hardware of the testing apparatus.

### Brief description of the Figures

Some examples of apparatuses and/or methods will be described in the following by way of example only, and with reference to the accompanying figures, in which

Fig. 1 illustrates a flowchart of an example of a method for determining at least one of a first CRES and a second CRES of a two-wire Kelvin connection;

Fig. 2 illustrates an exemplary first measurement;

Fig. 3 illustrates an exemplary second measurement;

Fig. 4 illustrates an exemplary third measurement;

Fig. 5 illustrates an extended representation of the measurement set-up illustrated in Figs. 2 to 4;

Fig. 6 illustrates a variation of the measurement set-up illustrated in Fig. 5; and

Fig. 7 illustrates a variation of the measurement set-up illustrated in Figs. 2 to 4.

**Detailed Description**

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e., only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

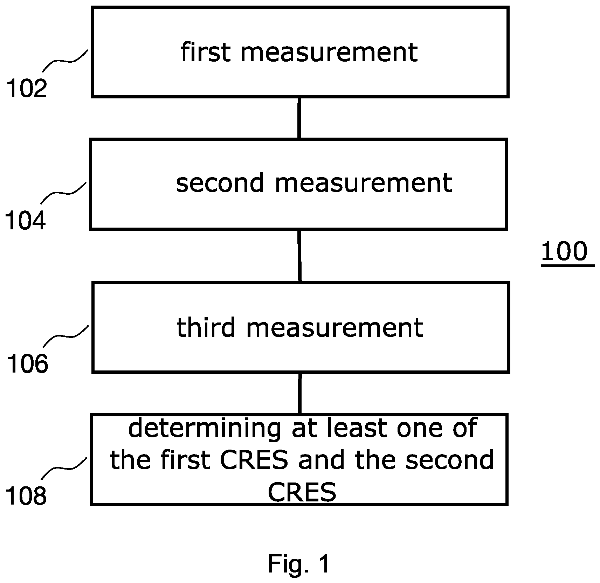

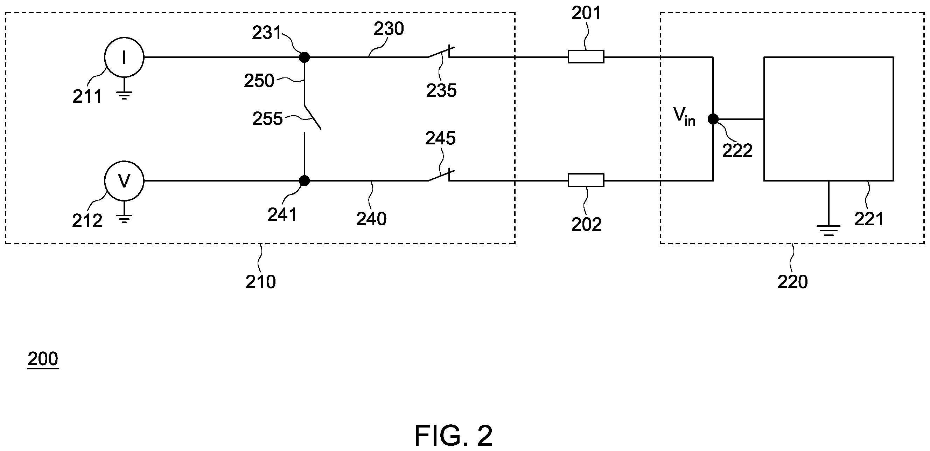

**Fig. 1** illustrates a flowchart of a method 100 for determining at least one of a first CRES and a second CRES of a two-wire Kelvin connection. The method 100 will be described in the following further with reference to the measurement set-up 200 illustrated in Figs. 2 to 4.

As illustrated in **Fig. 2**, the two-wire Kelvin connection couples a testing apparatus 210 with a DUT 220. The two-wire Kelvin connection is formed by contact of a first measurement path 230 and a second measurement path 240 of the testing apparatus 210 with the DUT 220.

The DUT 220 may be any electronic or electrical component or system that is to be tested, analyzed or evaluated by the testing apparatus 210. The DUT 220 comprises internal circuitry 221 such as one or more of ElectroStatic Discharge (ESD) protection circuitry, transistors, resistors, capacitors, inductors (e.g., coils) and integrated circuits. The internal circuitry 221 may comprise additional, fewer or different elements than those previously mentioned. The internal circuitry 221 of the DUT 220 may comprise analog circuitry, digital circuitry or a combination thereof. According to examples, the DUT 220 may be or comprise a semiconductor device (e.g., a radar device).

In addition to the first and second measurement paths 230, 240, the testing apparatus 210 comprises a current source 211 and a (e.g., high-ohmic) voltmeter 212. The first measurement path 230 is electrically connected (coupled) to the current source 211. The second measurement path 240 is electrically connected (coupled) to the voltmeter 212. The first measurement path 230 is for instance a force path of the testing apparatus 210. The second measurement path 240 is for instance a sense path of the testing apparatus 210.

The coupling of the first measurement path 230 and the second measurement path 240 to the DUT 220 is schematically illustrated in Fig. 2 by the coupling of the first measurement path 230 and the second measurement path 240 to the input node 222 of the internal circuitry 221 of the DUT 220. For example, the first measurement path 230 and the second measurement path 240 may both contact the DUT 220 via a respective contact element or probe head of the testing apparatus 210 such as a needle or a Pogo (i.e., a spring-loaded contact element or probe head). The respective contact element or probe head is not illustrated in Figs. 2 to 4 for reasons of simplicity. For example, the contact element or probe head may be integrated in a socket into which the DUT 220 is (to be) placed for testing, analysis or evaluation by the testing apparatus 210. The contact element or probe head may, e.g., contact at least one contact pad (test pad, landing) pad of the DUT 220. A contact pad is a conductive area of the DUT 220 for enabling contacting of the internal circuitry 221 of the DUT 220 by external devices such as the testing apparatus 210. The at least one contact pad is schematically represented in Fig. 2 by the input node 222.

As illustrated in Fig. 2, the first measurement path 230 and the second measurement path 240 each comprise a switch 235, 245 configured to switch between a conductive state and a non-conductive state to allow selective coupling of the corresponding measurement path 230, 240 to the DUT 220. For example, the switches 235, 245 may be relays.

A first node 231 of the first measurement path 230 and a second node 241 of the second measurement path 240 are electrically coupled by a coupling path 250. The first node 231 is arranged between the current source 211 and the switch 235. The second node 241 is arranged between the voltmeter 212 and the switch 245. The coupling path 250 is configured for selectively enabling and disabling flow of current between the first node 231 and the second node 241. In the example of Fig. 2, the coupling path includes a switch 255 configured to selectively electrically close and open the coupling path 250. Accordingly, the flow of current between the first node 231 and the second node 241 may be selectively enabled and disabled by electrically closing and opening the coupling path 250 via the switch 255. For example, the switch 255 may be a (Kelvin) relay.

At the points where the first measurement path 230 and the second measurement path 240 make contact with the DUT 220, a respective CRES is introduced. The first CRES of the first measurement 230 is represented by the resistor 201 in Fig. 2. Similarly, the second CRES of the second measurement path 240 is represented by the resistor 202 in Fig. 2. The CRES on the first measurement path 230 and the second measurement path 240 is a parasitic and unavoidable resistance and may vary on various parameters such as contamination, abrasion temperature, etc. The CRES may lead to inaccurate Kelvin measurements or even failure of Kelvin measurements.

For determining at least one of the first CRES of the first measurement path 230 and of the second CRES of the second measurement path 240, the method 100 comprises (performing) a first measurement 102 with both the first measurement path 230 and the second measurement path 240 coupled to the DUT 220. For the first measurement 102, the switches 235, 245 are in the conductive state to couple both the first measurement path 230 and the second measurement path 240 to the DUT 220.

The current source 211 coupled to the first measurement path 230 is configured to supply (provide) a predefined measurement current $I_{meas}$. The measurement current $I_{meas}$ is a constant current, i.e., a current that does not vary over time. The measurement current $I_{meas}$ may be a small current. For example, the measurement current $I_{meas}$ may be -1 mA or more and 1 mA or less. In some examples, the measurement current $I_{meas}$ may be -100 μA. As the switch 235 is in the conductive state, the first measurement path 230 carries the predefined measurement current $I_{meas}$ to the DUT 220. In other words, the first measurement 102 comprises supplying the predefined measurement current $I_{meas}$ to the DUT 220 via the first measurement path 230.

The switch 255 opens the coupling path 250 in the first measurement 102 such that no current flows in the coupling path 250 between the first node 231 and the second node 241 in the first measurement. Accordingly, no current flows in the second measurement path 240.

The voltage measured by the voltmeter 212 is the voltage $V_{in}$ at the input node 222 of the DUT 220's internal circuitry 221. In other words, the first measurement 102 comprises measuring a first voltage $V_1 = V_{in}$ at the input node 222 of the DUT 220's internal circuitry 221 to which the first and second measurement path 230, 240 are coupled.

The method 100 further comprises (performing) at least one of a second measurement 104 for determining the first CRES and a third measurement 106 for determining the second CRES. In some examples, only one of the second measurement 104 and the third measurement 106 may be performed. In other examples, both of the second measurement 104 and the third measurement 106 may be performed so as to determine both the first CRES and the second CRES.

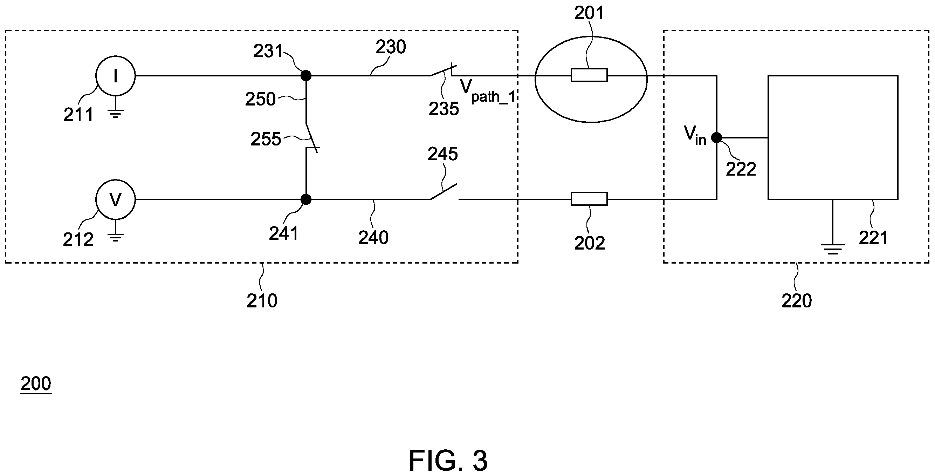

The second measurement 104 is illustrated in **Fig. 3.** As illustrated in Fig. 3, the switch 235 is in the conductive state and the switch 245 is in the non-conductive state for the second measurement 104. Accordingly, only the first measurement path 230 is coupled to the DUT 220 in the second measurement 104. The second measurement path 240 is decoupled from the DUT 220 in the second measurement 104.

The switch 255 closes the coupling path 250 in the second measurement 104. No current flows in the coupling path 250 between the first node 231 and the second node 241 in the second measurement 104. The second measurement path 240 is open, i.e., no current flows in the second measurement path 240.

As the switch 235 is in the conductive state, the first measurement path 230 carries the predefined measurement current $I_{meas}$ to the DUT 220. In other words, the second measurement 104 comprises supplying the predefined measurement current $I_{meas}$ to the DUT 220 via the first measurement path 230.

The voltage measured by the voltmeter 212 is the voltage at the first node 231 of the first measurement path 230. The voltage at the first node 231 of the first measurement path 230 is the sum of the voltage $V_{in}$ at the input node 222 of the DUT 220's internal circuitry 221 and the voltage drop $V_{path\_1}$ at the first measurement path 230. In other words, the second measurement 104 comprises measuring a second voltage $V_2 = V_{in} + V_{path\_1}$ at the first node 231 of the first measurement path 230.

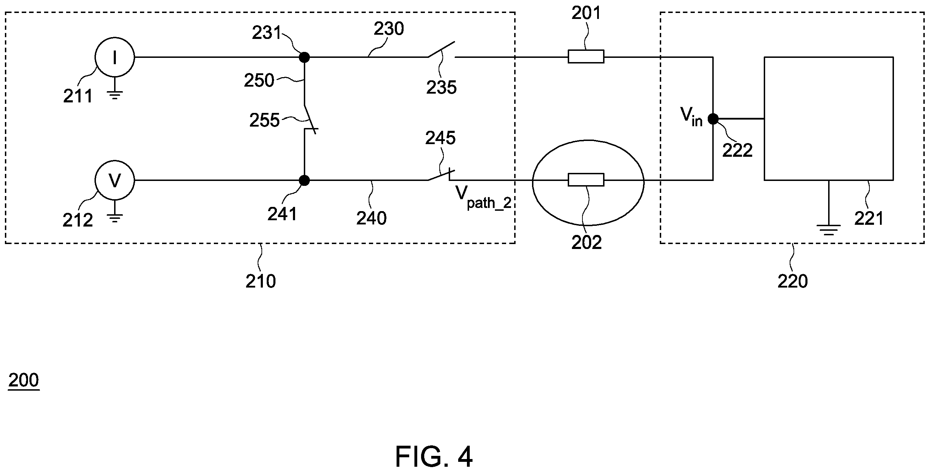

The third measurement 106 is illustrated in **Fig. 4.** As illustrated in Fig. 4, the switch 245 is in the conductive state and the switch 235 is in the non-conductive state for the third measurement 106. Accordingly, only the second measurement path 240 is coupled to the DUT 220 in the third measurement 106. The first measurement path 230 is decoupled from the DUT 220 in the third measurement 106.

The switch 255 closes the coupling path 250 in the third measurement 106. Accordingly, current (the measurement current $I_{meas}$) flows in the coupling path 250 between the first node 231 and the second node 241 in the third measurement 106. The first measurement path 230 is open, i.e., no current flows in the first measurement path 230.

As the switch 245 is in the conductive state, the second measurement path 240 carries the predefined measurement current $I_{meas}$ to the DUT 220. In other words, the third measurement 106 comprises supplying the predefined measurement current $I_{meas}$ to the DUT 220 via the second measurement path 240.

The voltage measured by the voltmeter 212 is the voltage at the second node 241 of the second measurement path 240. The voltage at the second node 241 of the second measurement path 240 is the sum of the voltage $V_{in}$ at the input node 222 of the DUT 220's internal circuitry 221 and the voltage drop $V_{path\_2}$ at the second measurement path 240. In other words, the third measurement 106 comprises measuring a third voltage $V_3 = V_{in} + V_{path\_2}$ at the second node 241 of the second measurement path 240.

The predefined measurement current $I_{meas}$ is identical in each of the first to third measurements 102, 104 and 106. No current flows between the voltmeter 212 and the second node 241 in each of the first to third measurements 102, 104 and 106. In other words, the voltmeter 212 is a high-ohmic (high-Z) voltmeter.

It is to be noted that the first to third measurements 102, 104 and 106 may be performed in any temporal order. For example, the second measurement 104 may be performed after the first measurement 102 and the third measurement 106 may be performed after the second measurement 104. In other examples, one or both of the second measurement 104 and the third measurement 106 may be performed before the first measurement 102.

The voltages measured in the first to third measurements 102, 104 and 106 are used to determine the first CRES and/or the second CRES according to the proposed technology. In other words, the method 100 further comprises determining 108 at least one of the first CRES and the second CRES. The first CRES is determined based on the predefined measurement current $I_{meas}$, the first voltage $V_1$ and the second voltage $V_2$. The second CRES is determined based on the predefined measurement current $I_{meas}$, the first voltage $V_1$ and the third voltage $V_3$.

The first voltage $V_1$ allows to compensate for the voltage component voltage corresponding to the voltage $V_{in}$ at the input node 222 of the DUT 220's internal circuitry 221 in each of the second voltage $V_2$ and the third voltage $V_3$. The remaining component of second voltage $V_2$ and the third voltage $V_3$ relates to the voltage drop at the respective measurement path. The voltage drop is caused by the respective CRES for the predefined measurement current. This may be expressed as follows:

$$V_{path\_1} = CRES_{path\_1} \cdot I_{meas} \qquad (1)$$

$$V_{path\_2} = CRES_{path\_2} \cdot I_{meas} \qquad (2)$$

with $CRES_{path\_1}$ denoting the first CRES of the first measurement path 230 and $CRES_{path\_2}$ denoting the second CRES of the second measurement path 240.

The method 100 allows to determine the first CRES of the first measurement path 230 and/or the second CRES of the second measurement path 240 for each measurement path or wire of the two-wire Kelvin connection individually and without any additional resources or components. In high-volume production of the DUT, as no additional resources or components are needed than those for the actual Kelvin measurement with the two-wire Kelvin connection, available testing resources may be used to test more DUTs in parallel. In other words, test parallelism may be increased. Furthermore, the test time for the individual DUT 220 may be reduced.

Knowing the CRES of one or both measurement paths allows to perform more accurate Kelvin measurements as there are no parasitics from other components. For example, if there is a high CRES on the first measurement path (force path) 230, then the testing device 210 may attempt to compensate for this by conducting more current and/or voltage during a Kelvin measurement of the DUT 220. This may lead to an excessive voltage or overvoltage, which in turn may cause damage to the testing device 210 or components thereof. Accordingly, determining or monitoring the first CRES on the first measurement path 230 may allow to prevent damage to the testing device 210 due to overvoltage. Additionally, determining or monitoring the first CRES on the first measurement path 230 may allow monitor the contact quality of the contact between the first measurement path 230 and the DUT 220. During a Kelvin measurement, no current flows in the second measurement path 240 - analogously to the first measurement. Hence, a high CRES on the second measurement path (sense path) 240 is not critical. However, determining or monitoring the second CRES on the second measurement path 240 may allow to monitor the contact quality of the contact between the second measurement path 240 and the DUT 220.

The first CRES may, e.g., be determined based on a difference between the second voltage $V_2$ and the first voltage $V_1$. For example, the first CRES may be determined based on a quotient of the difference between the second voltage $V_2$ and the first voltage $V_1$ and the predefined measurement current $I_{meas}$:

$$CRES_{path\_1} \cong \frac{V_2 - V_1}{I_{meas}} = \frac{V_{in} + V_{path_1} - V_{in}}{I_{meas}} = \frac{V_{path\_1}}{I_{meas}} \qquad (3)$$

Analogously, the second CRES may, e.g., be determined based on a difference between the third voltage $V_3$ and the first voltage $V_1$. For example, the second CRES may be determined based on a quotient of the difference between the third voltage $V_3$ and the first voltage $V_1$ and the predefined measurement current $I_{meas}$:

$$CRES_{path\_2} \cong \frac{V_3 - V_1}{I_{meas}} = \frac{V_{in} + V_{path_2} - V_{in}}{I_{meas}} = \frac{V_{path\_2}}{I_{meas}} \qquad (4)$$

The first voltage $V_1$ is used as a reference for the calculation of the individual CRES for one or both of the first measurement path 230 and the second measurement path 240. The voltage $V_{in}$ at the input node 222 of the DUT 220's internal circuitry 221 is basically identical for each of the first to third measurements 102, 104 and 106.

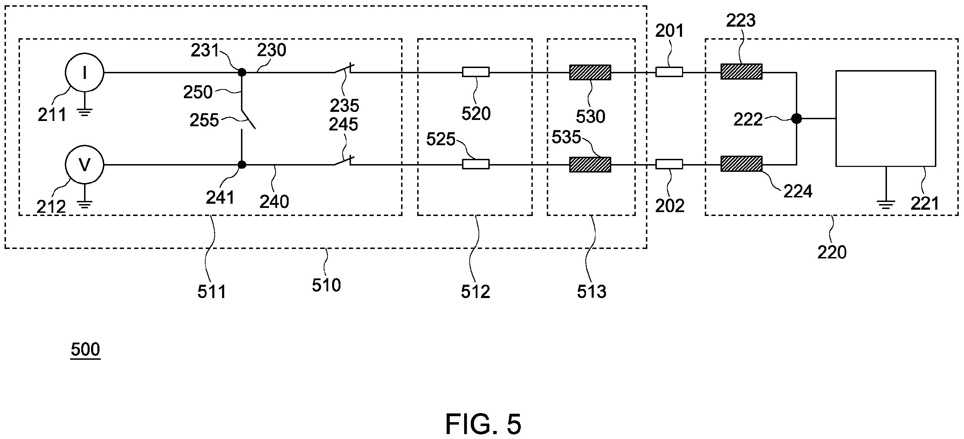

As indicated above, the first measurement path 230 and the second measurement path 240 may be coupled to the DUT 220 via intermediate elements such as contact elements or probe heads. An extended representation of the measurement set-up 200 illustrated in Figs. 2 to 4 further highlighting the additional intermediate elements is illustrated in **Fig. 5.** The measurement set-up 500 illustrated in Fig. 5 is based on the measurement set-up 200 illustrated in Figs. 2 to 4. In the following only the differences between the measurement set-ups 200 and 500 will be described. The contact pad of the DUT 220 is represented in Fig. 2 by the elements 222 and 223.

Similarly to the measurement set-up 200, the measurement set-up 500 comprises a testing device 510. The testing device 510 comprises a tester such as an Automatic Test Equipment (ATE) 511 which comprise the current source 211, the voltmeter 212, the switches 235 and 245, the coupling path 250 and part of the first and second measurement paths 230 and 240. The functionalities of the aforementioned elements is as described above.

The measurement set-up 500 further comprises a PCB 512 for coupling the tester 511 to a contact element (probe head) 513. The contact element 513 is formed by a first needle or Pogo 530 for the first measurement path 230 and a second needle or Pogo 535 for the second measurement path 240. In other words, a respective needle or Pogo is arranged on each of the first measurement path 230 and the second measurement path 240. For example, the contact element 513 may be integrated in a socket into which the DUT 220 is (to be) placed for testing, analysis or evaluation by the testing apparatus 510. The PCB 512 comprises conductive traces and optionally electronic circuitry for coupling the tester 511 to the contact element 513. The conductive traces and the optional electronic circuitry of the PCB 512 provide an additional resistance for each of the first measurement path 230 and the second measurement path 240. The additional resistance is represented by resistors 520 and 525 in the first and second measurement paths 230 and 240 in Fig. 5. Similarly, the needles or Pogos 530 and 535 provide an additional resistance for each of the first measurement path 230 and the second measurement path 240.

The PCB 512 and the contact element 513 may each be understood as a hardware element which includes one or more hardware resistor arranged on at least one of the first measurement path 230 and the second measurement path 240.

The voltage drop at the respective measurement path depends not only on the respective CRES for the predefined measurement current but further on the additional resistance(s) provided to the respective measurement path. This may be expressed as follows:

$$V_{path\_1} = \left( CRES_{path\_1} + R_{path\_1} \right) \cdot I_{meas} \qquad (5)$$

$$V_{path\_2} = \left( CRES_{path\_2} + R_{path\_2} \right) \cdot I_{meas} \qquad (6)$$

with $R_{path\_1}$ denoting the additional resistance(s) provided to the first measurement path 230 and $R_{path\_2}$ denoting the additional resistance(s) provided to the second measurement path 240.

These resistances may optionally be considered when calculating the first CRES of the first measurement path 230 and the second CRES of the second measurement path 240. In particular, mathematical expressions (3) and (4) described above may be modified as follows to compensate for the additional hardware resistor(s):

$$CRES_{path\_1} \cong \frac{V_2 - V_1}{I_{meas}} - R_{path_1} = \frac{V_{in} + V_{path_1} - V_{in}}{I_{meas}} - R_{path_1} = \frac{V_{path_1}}{I_{meas}} - R_{path_1} \qquad (7)$$

$$CRES_{path\_2} \cong \frac{V_3 - V_1}{I_{meas}} - R_{path_2} = \frac{V_{in} + V_{path_2} - V_{in}}{I_{meas}} - R_{path_2} = \frac{V_{path_2}}{I_{meas}} - R_{path\_2} \qquad (8)$$

In other words, if the testing apparatus includes a hardware element which includes one or more hardware resistor arranged on at least one of the first measurement path 230 and the second measurement path 240, the at least one of the first CRES and the second CRES may be further determined based on a resistance value of the one or more hardware resistor.

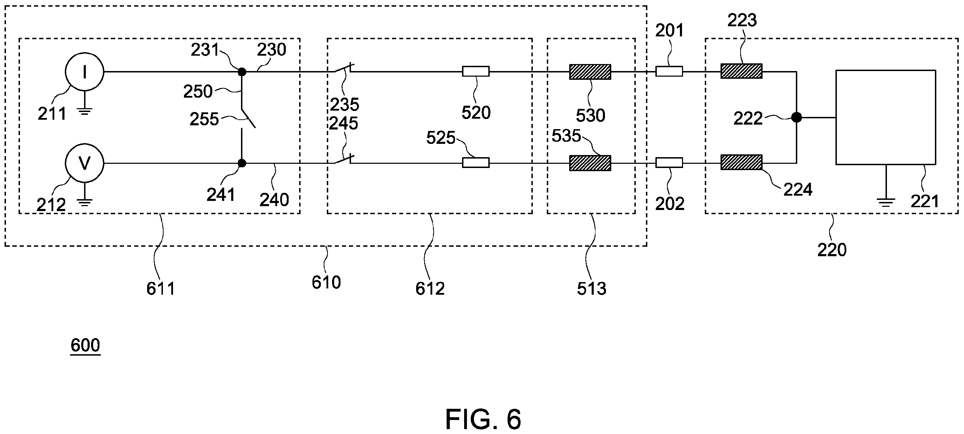

In the example of Fig. 5, the tester 511 comprises the switches 235 and 245 for selectively coupling and decoupling the first and second measurement paths 230 and 240 to/from the DUT 220. However, the present disclosure is not limited thereto. **Fig. 6** illustrates an alternative measurement set-up 600 with a testing device 610. Compared to the measurement set-up 500 illustrated in Fig. 5, the tester 611 does not comprise the switches 235 and 245. Instead, the PCB 612 comprises the switches 235 and 245. The functionality of the switches 235 and 245 is as described above. As is evident from the measurement set-ups 500 and 600, the positioning of the switches 235 and 245 within the testing device (i.e., along the measurement paths 230 and 240) is not essential for the method 100. Alternatively or additionally, the coupling path 250 may be shifted to the PCB 612 according to examples of the present disclosure.

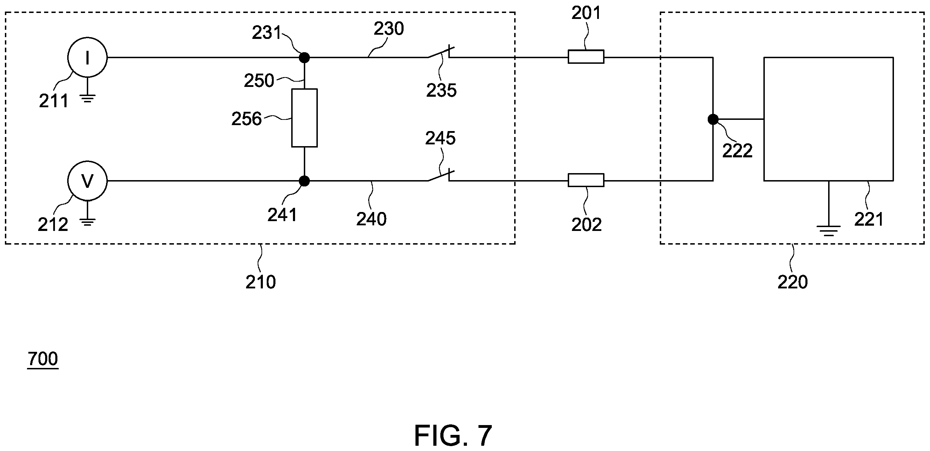

In each of the above examples, the coupling path 250 comprises the switch 255 for selectively enabling and disabling flow of current between the first node 231 and the second node 241. However, the proposed technology is not limited thereto. According to examples, the switch 255 may be replaced by a (Kelvin) resistor. A corresponding measurement set-up 700 is illustrated in **Fig. 7.** In comparison to the measurement set-up 200, the switch 255 is replaced by a (Kelvin) resistor 256. Like the switch 255, the resistor 256 may allow to suppress the flow of current in the coupling path 250 between the first node 231 and the second node 241 in the first measurement 102 and in the second measurement 104. Similarly, the resistor 256 may allow current flow in the coupling path 250 between the first node 231 and the second node 241 in the third measurement 106. A resistance of the resistor 256 may be selected accordingly.

In the measurement set-ups 500 and 600 illustrated in Fig. 5 and Fig. 6, the switch 255 may be replaced by the resistor 256 analogously.

In alternative examples, the resistor 256 may be placed in the coupling path 250 in addition to the switch 255.

Any of the testing devices 210, 510, 610 and 710 may be configured to perform the method 100. For example, the testing devices 210, 510, 610 and 710 may be configured to automatically perform the method 100. According to examples, the testing devices 210, 510, 610 and 710 comprise memory configured to store a program having a program code which, when executed by the respective testing device 210, 510, 610 or 710, causes the testing device to perform the steps and methods described herein.

In alternative examples, the method 100 may be performed manually. In these examples, the switches 235, 245 and 255 may, e.g., be manually controllable switches. Further alternatively, the switches 235, 245 and 255 may be omitted and the measurement paths 230 and 240 may be individually decoupled/disconnected from the DUT 220 by unplugging. Similarly, current flow on the coupling path 250 may be suppressed by unplugging the coupling path 250 from one or both of the measurement paths 230 and 240.

Examples of the present disclosure may allow estimation of the CRES on a two-wire Kelvin connection without use of any additional instruments or components.

The examples described herein may be summarized as follows:

An example (e.g., example 1) relates to a method for determining at least one of a first CRES and a second CRES of a two-wire Kelvin connection formed by contact of a first measurement path and a second measurement path of a testing apparatus with a DUT. The method comprises, during a first measurement with both the first measurement path and the second measurement path coupled to the DUT, supplying a predefined measurement current to the DUT via the first measurement path and measuring a first voltage at an input node of internal circuitry of the DUT to which the first and second measurement path are coupled. The method further comprises at least one of a second measurement with only the first measurement path coupled to the DUT for determining the first CRES and a third measurement with only the second measurement path coupled to the DUT for determining the second CRES. Said second measurement comprises supplying the predefined measurement current to the DUT via the first measurement path and measuring a second voltage at a first node of the first measurement path. Said third measurement comprises supplying the predefined measurement current to the DUT via the second measurement path and measuring a third voltage at a second node of the second measurement path. The method further comprises determining the at least one of the first CRES and the second CRES. The first CRES is determined based on the predefined measurement current, the first voltage and the second voltage. The second CRES is determined based on the predefined measurement current, the first voltage and the third voltage.

Another example (e.g., example 2) relates to a previous example (e.g., example 1) or to any other example, wherein the first CRES is determined based on a difference between the second voltage and the first voltage, and the second CRES is determined based on a difference between the third voltage and the first voltage.

Another example (e.g., example 3) relates to a previous example (e.g., example 2) or to any other example, wherein the first CRES is determined based on a quotient of the difference between the second voltage and the first voltage and the predefined measurement current, and wherein the second CRES is determined based on a quotient of the difference between the third voltage and the first voltage and the predefined measurement current.

Another example (e.g., example 4) relates to a previous example (e.g., one of the examples 1 to 3) or to any other example, wherein the testing apparatus includes a hardware element which includes one or more hardware resistor arranged on at least one of the first measurement path and the second measurement path, the at least one of the first CRES and the second CRES being further determined based on a resistance value of the one or more hardware resistor.

Another example (e.g., example 5) relates to a previous example (e.g., one of the examples 1 to 4) or to any other example, wherein the first measurement path is a force path of the testing apparatus, and the second measurement path is a sense path of the testing apparatus.

Another example (e.g., example 6) relates to a previous example (e.g., one of the examples 1 to 5) or to any other example, wherein the measurement current is -1 mA or more and 1 mA or less.

Another example (e.g., example 7) relates to a previous example (e.g., one of the examples 1 to 6) or to any other example, wherein the first measurement path is connected to a current source configured to supply the predefined measurement current, and wherein the second measurement path is connected to a voltmeter.

Another example (e.g., example 8) relates to a previous example (e.g., one of the examples 1 to 7) or to any other example, wherein no current flows between the voltmeter and the second node in each of the first to third measurements.

Another example (e.g., example 9) relates to a previous example (e.g., one of the examples 1 to 8) or to any other example, wherein the first node and the second node are electrically coupled by a coupling path, and wherein the coupling path is configured for selectively enabling and disabling flow of current between the first node and the second node.

Another example (e.g., example 10) relates to a previous example (e.g., example 9) or to any other example, wherein no current flows in the coupling path between the first node and the second node in the first measurement and in the second measurement, and wherein current flows in the coupling path in the third measurement.

Another example (e.g., example 11) relates to a previous example (e.g., one of the examples 9 or 10) or to any other example, wherein the coupling path includes a switch configured to selectively electrically close and open the coupling path.

Another example (e.g., example 12) relates to a previous example (e.g., one of the examples 1 to 11) or to any other example, wherein the first measurement path and the second measurement path each comprise a switch configured to switch between a conductive state and a non-conductive state to allow selective coupling of the corresponding measurement path to the DUT.

Another example (e.g., example 13) relates to a testing apparatus configured to perform the method according to a previous example (e.g., one of the examples 1 to 12) or to any other example.

Another example (e.g., example 14) relates to a non-transitory machine-readable medium having stored thereon a program having a program code for causing a testing apparatus to perform the method according to a previous example (e.g., one of the examples 1 to 12) or to any other example, when the program is executed on a processor or a programmable hardware of the testing apparatus.

Another example (e.g., example 15) relates to a program having a program code for causing a testing apparatus to perform the method according to a previous example (e.g., one of the examples 1 to 12) or to any other example, when the program is executed on a processor or a programmable hardware of the testing apparatus.

The aspects and features described in relation to a particular one of the previous examples may also be combined with one or more of the further examples to replace an identical or similar feature of that further example or to additionally introduce the features into the further example.

Examples may further be or relate to a (computer) program including a program code to execute one or more of the above methods when the program is executed on a computer, processor or other programmable hardware component. Thus, steps, operations or processes of different ones of the methods described above may also be executed by programmed computers, processors or other programmable hardware components. Examples may also cover program storage devices, such as digital data storage media, which are machine-, processor- or computer-readable and encode and/or contain machine-executable, processor-executable or computer-executable programs and instructions. Program storage devices may include or be digital storage devices, magnetic storage media such as magnetic disks and magnetic tapes, hard disk drives, or optically readable digital data storage media, for example. Other examples may also include computers, processors, control units, (field) programmable logic arrays ((F)PLAs), (field) programmable gate arrays ((F) PGAs), graphics processor units (GPU), application-specific integrated circuits (ASICs), integrated circuits (ICs) or system-on-a-chip (SoCs) systems programmed to execute the steps of the methods described above.

It is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process or operation may include and/or be broken up into several substeps, -functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

1. A method (100) for determining at least one of a first contact resistance and a second contact resistance of a two-wire Kelvin connection formed by contact of a first measurement path and a second measurement path of a testing apparatus with a Device Under Test, DUT, the method (100) comprising:

   during a first measurement (102) with both the first measurement path and the second measurement path coupled to the DUT, supplying a predefined measurement current to the DUT via the first measurement path and measuring a first voltage at an input node of internal circuitry of the DUT to which the first and second measurement path are coupled;
   the method (100) further comprising at least one of:

   a second measurement (104) with only the first measurement path coupled to the DUT for determining the first contact resistance, said second measurement comprising supplying the predefined measurement current to the DUT via the first measurement path and measuring a second voltage at a first node of the first measurement path; and
   a third measurement (106) with only the second measurement path coupled to the DUT for determining the second contact resistance, said third measurement comprising supplying the predefined measurement current to the DUT via the second measurement path and measuring a third voltage at a second node of the second measurement path;

   the method (100) further comprising determining (108) the at least one of the first contact resistance and the second contact resistance, the first contact resistance being determined based on the predefined measurement current, the first voltage and the second voltage, the second contact resistance being determined based on the predefined measurement current, the first voltage and the third voltage.

2. The method (100) of claim 1, wherein:

   the first contact resistance is determined based on a difference between the second voltage and the first voltage, and
   the second contact resistance is determined based on a difference between the third voltage and the first voltage.

3. The method (100) of claim 2, wherein the first contact resistance is determined based on a quotient of the difference between the second voltage and the first voltage and the predefined measurement current, and wherein the second contact resistance is determined based on a quotient of the difference between the third voltage and the first voltage and the predefined measurement current.

4. The method (100) of any one of the preceding claims, wherein the testing apparatus includes a hardware element which includes one or more hardware resistor arranged on at least one of the first measurement path and the second measurement path, the at least one of the first contact resistance and the second contact resistance being further determined based on a resistance value of the one or more hardware resistor.

5. The method (100) of any one of the preceding claims, wherein the first measurement path is a force path of the testing apparatus, and the second measurement path is a sense path of the testing apparatus.

6. The method (100) of any one of the preceding claims, wherein the predefined measurement current is -1 mA or more and 1 mA or less.

7. The method (100) of any of the preceding claims, wherein the first measurement path is connected to a current source configured to supply the predefined measurement current, and wherein the second measurement path is connected to a voltmeter.

8. The method (100) of any of the preceding claims, wherein no current flows between the voltmeter and the second node in each of the first to third measurements.

9. The method (100) of any of the preceding claims, wherein the first node and the second node are electrically coupled by a coupling path, and wherein the coupling path is configured for selectively enabling and disabling flow of current between the first node and the second node.

10. The method (100) of claim 9, wherein no current flows in the coupling path between the first node and the second node in the first measurement and in the second measurement, and wherein current flows in the coupling path in the third measurement.

11. The method (100) of claim 9 or 10, wherein the coupling path includes a switch configured to selectively electrically close and open the coupling path.

12. The method (100) of any one of claims 1 to 11, wherein the first measurement path and the second measurement path each comprise a switch configured to switch between a conductive state and a non-conductive state to allow selective coupling of the corresponding measurement path to the DUT.

13. A testing apparatus (210, 510, 610) configured to perform the method according to any one of claims 1 to 12.

14. A non-transitory machine-readable medium having stored thereon a program having a program code for causing a testing apparatus to perform the method according to any one of claims 1 to 12, when the program is executed on a processor or a programmable hardware of the testing apparatus.

15. A program having a program code for causing a testing apparatus to perform the method according to any one of claims 1 to 12, when the program is executed on a processor or a programmable hardware of the testing apparatus.

**Amended claims in accordance with Rule 137(2) EPC.**

1. A method (100) for determining at least one of a first contact resistance and a second contact resistance of a two-wire Kelvin connection formed by contact of a first measurement path and a second measurement path of a testing apparatus with a Device Under Test, DUT, the method (100) comprising:

   during a first measurement (102) with both the first measurement path and the second measurement path coupled to the DUT, supplying a predefined measurement current to the DUT via the first measurement path and measuring a first voltage at an input node of internal circuitry of the DUT to which the first and second measurement path are coupled;
   the method (100) further comprising at least one of:

   a second measurement (104) with only the first measurement path coupled to the DUT for determining the first contact resistance, said second measurement comprising supplying the predefined measurement current to the DUT via the first measurement path and measuring a second voltage at a first node of the first measurement path; and
   a third measurement (106) with only the second measurement path coupled to the DUT for determining the second contact resistance, said third measurement comprising supplying the predefined measurement current to the DUT via the second measurement path and measuring a third voltage at a second node of the second measurement path;

   the method (100) further comprising determining (108) the at least one of the first contact resistance and the second contact resistance, the first contact resistance being determined based on the predefined measurement current, the first voltage and the second voltage, the second contact resistance being determined based on the predefined measurement current, the first voltage and the third voltage,
wherein the first node and the second node are electrically coupled by a coupling path, and
wherein the coupling path is configured for selectively enabling and disabling flow of current between the first node and the second node.

2. The method (100) of claim 1, wherein:

the first contact resistance is determined based on a difference between the second voltage and the first voltage, and
the second contact resistance is determined based on a difference between the third voltage and the first voltage.

3. The method (100) of claim 2, wherein the first contact resistance is determined based on a quotient of the difference between the second voltage and the first voltage and the predefined measurement current, and wherein the second contact resistance is determined based on a quotient of the difference between the third voltage and the first voltage and the predefined measurement current.

4. The method (100) of any one of the preceding claims, wherein the testing apparatus includes a hardware element which includes one or more hardware resistor arranged on at least one of the first measurement path and the second measurement path, the at least one of the first contact resistance and the second contact resistance being further determined based on a resistance value of the one or more hardware resistor.

5. The method (100) of any one of the preceding claims, wherein the first measurement path is a force path of the testing apparatus, and the second measurement path is a sense path of the testing apparatus.

6. The method (100) of any one of the preceding claims, wherein the predefined measurement current is -1 mA or more and 1 mA or less.

7. The method (100) of any of the preceding claims, wherein the first measurement path is connected to a current source configured to supply the predefined measurement current, and wherein the second measurement path is connected to a voltmeter.

8. The method (100) of any of the preceding claims, wherein no current flows between the voltmeter and the second node in each of the first to third measurements.

9. The method (100) of any one of the preceding claims, wherein no current flows in the coupling path between the first node and the second node in the first measurement and in the second measurement, and wherein current flows in the coupling path in the third measurement.

10. The method (100) of claim 9, wherein the coupling path includes a switch configured to selectively electrically close and open the coupling path.

11. The method (100) of any one of claims 1 to 10, wherein the first measurement path and the second measurement path each comprise a switch configured to switch between a conductive state and a non-conductive state to allow selective coupling of the corresponding measurement path to the DUT.

12. A testing apparatus (210, 510, 610) configured to perform the method according to any one of claims 1 to 11.

13. A non-transitory machine-readable medium having stored thereon a program having a program code for causing a testing apparatus according to claim 12 to perform the method according to any one of claims 1 to 11, when the program is executed on a processor or a programmable hardware of the testing apparatus.

14. A program having a program code for causing a testing apparatus according to claim 12 to perform the method according to any one of claims 1 to 11, when the program is executed on a processor or a programmable hardware of the testing apparatus.

first measurement

102

second measurement

104

100

third measurement

106

determining at least one of the first CRES and the second CRES

108

Fig. 1

FIG. 2

EP 4 653 882 A1

FIG. 3

EP 4 653 882 A1

FIG. 4

FIG. 5

FIG. 6

EP 4 653 882 A1

FIG. 7

700

EP 4 653 882 A1

EP 4 653 882 A1

Europäisches
Patentamt
European
Patent Office
Office européen
des brevets

# EUROPEAN SEARCH REPORT

**Application Number**

EP 24 17 7381

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/038340 A1 (MASUDA NORIYUKI [JP]) 14 February 2013 (2013-02-14) | 1-8, 12-15 | INV. G01R27/14 G01R27/08 |
| A | * figures 2,4-6 * | 9-11 | |
| A | CA 1 213 324 A (NORTHERN TELECOM LTD) 28 October 1986 (1986-10-28) * paragraph [0010]; figure 3 * | 1-15 | |
| A | CN 110 426 622 A (BEIJING HUAFENG MEASUREMENT AND CONTROL TECH CO LTD ET AL.) 8 November 2019 (2019-11-08) * figure 1 * | 1-15 | |
| A | JP S55 119066 A (YOKOGAWA ELECTRIC WORKS LTD) 12 September 1980 (1980-09-12) * the whole document * | 1-10 | |

**TECHNICAL FIELDS SEARCHED (IPC)**

G01R

The present search report has been drawn up for all claims

| Place of search | Date of completion of the search | Examiner |
|---|---|---|
| Munich | 31 October 2024 | Schindler, Martin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

19

## ANNEX TO THE EUROPEAN SEARCH REPORT
## ON EUROPEAN PATENT APPLICATION NO.

EP 24 17 7381

This annex lists the patent family members relating to the patent documents cited in the above-mentioned European search report.
The members are as contained in the European Patent Office EDP file on
The European Patent Office is in no way liable for these particulars which are merely given for the purpose of information.

31-10-2024

| Patent document cited in search report | | Publication date | Patent family member(s) | | Publication date |
|---|---|---|---|---|---|
| US 2013038340 | A1 | 14-02-2013 | JP WO2011151856 | A1 | 25-07-2013 |
| | | | KR 20120139795 | A | 27-12-2012 |
| | | | TW 201142312 | A | 01-12-2011 |
| | | | US 2013038340 | A1 | 14-02-2013 |
| | | | WO 2011151856 | A1 | 08-12-2011 |
| CA 1213324 | A | 28-10-1986 | NONE | | |
| CN 110426622 | A | 08-11-2019 | NONE | | |
| JP S55119066 | A | 12-09-1980 | NONE | | |

EPO FORM P0459

For more details about this annex : see Official Journal of the European Patent Office, No. 12/82